# EUROPÄISCHE PATENTSCHRIFT

(11) **EP 1 492 130 B1**
(45) Veröffentlichungstag und Bekanntmachung des Hinweises auf die Patenterteilung: **04.10.2006**
(21) Anmeldenummer: 04009119.1
(22) Anmeldetag: 16.04.2004
(51) Int. Cl.: H01C 1/14, H01C 1/16, H01C 17/28, G01R 19/00

(54) **Widerstandsanordnung, Herstellungsverfahren und Messschaltung**
Resistor arrangement, process for production and measuring circuit
Dispositif résistif, procédé de fabrication et circuit de mesure

(30) Priorität: 26.06.2003 DE 10328870
(43) Veröffentlichungstag der Anmeldung: 29.12.2004
(73) Patentinhaber: Isabellenhütte Heusler GmbH & Co.KG, 35683 Dillenburg (DE)
(72) Erfinder: Hetzler, Ullrich, 35688 Dillenburg-Oberscheid (DE)
(74) Vertreter: Beier, Ralph

(56) Entgegenhaltungen:
- EP-A- 0 605 800
- EP-A- 0 716 427
- EP-A- 1 313 109
- DE-A- 2 634 743
- DE-U- 29 616 313

## Beschreibung

Die Erfindung betrifft eine Widerstandsanordnung, insbesondere zur Strommessung in einem Kfz-Bordnetz, gemäß dem Oberbegriff des Anspruchs 1, ein Herstellungsverfahren für eine derartige Widerstandsanordnung gemäß dem Oberbegriff von Anspruch 12 sowie eine Messschaltung mit einer derartigen Widerstandsanordnung gemäß Anspruch 17.

Aus EP 0 605 800 B1, EP 1 030 185 A2 und EP 0 716 427 B1 sind niederohmige Widerstandsanordnungen bekannt, die zur Messung hoher Ströme eingesetzt werden können. Diese bekannten Widerstandsanordnungen bestehen aus zwei voneinander getrennten, wenigstens teilweise plattenförmigen Anschlusselementen zur Stromeinspeisung bzw. Stromabführung und einem zwischen den beiden Anschlusselementen angeordneten und mit diesen elektrisch und mechanisch verbundenen plattenförmigen Widerstandselement, wobei die Verbindung des Widerstandselements mit den angrenzenden Anschlusselementen durch eine Verschweißung erfolgt. Weiterhin weist die bekannte Widerstandsanordnung zwei separate Messanschlüsse auf, um entsprechend der bekannten Vierleitertechnik die über dem Widerstandselement abfallende elektrische Spannung zu messen, woraus nach dem Ohmschen Gesetz der durch das Widerstandselement fließende elektrische Strom berechnet werden kann.

Nachteilig an dieser bekannten Widerstandsanordnung ist jedoch die Tatsache, dass zur Messung mehrerer Ströme eine entsprechend große Anzahl von Widerstandsanordnungen erforderlich ist.

Weiterhin ist aus DE 26 34 743 A1 eine Widerstandsanordnung bekannt, die elektrisch sternförmig geschaltet ist und somit die Messung mehrerer Ströme ermöglicht. Allerdings ist diese bekannte Widerstandsanordnung einstückig ausgebildet, so dass die Anschlusselemente und die Widerstandselemente aus demselben Material bestehen, was nur eine unbefriedigende Messgenauigkeit ermöglicht.

Aus DE 296 16 313 U1 ist eine weitere Widerstandsanordnung bekannt, die ebenfalls die Messung mehrerer Ströme ermöglicht, jedoch ermöglicht diese bekannte Widerstandsanordnung keine kostengünstige und effektive Massenfertigung. Schließlich ist aus EP 1 313 109 A2 ein SMD-Messwiderstand bekannt, der jedoch ebenfalls nur die Messung eines einzigen Stroms ermöglicht.

Der Erfindung liegt deshalb die Aufgabe zugrunde, den Aufwand zur Messung mehrerer unterschiedlicher elektrischer Ströme zu verringern.

Diese Aufgabe wird, ausgehend von der eingangs beschriebenen bekannten Widerstandsanordnung gemäß dem Oberbegriff des Anspruchs 1, durch die kennzeichnenden Merkmale des Anspruchs 1 und - hinsichtlich eines entsprechenden Herstellungsverfahrens - durch die Merkmale des Anspruchs 12 bzw. durch eine Messschaltung gemäß Anspruch 17 gelöst.

Die Erfindung umfasst die allgemeine technische Lehre, die eingangs beschriebene bekannte Widerstandsanordnung dahingehend zu verbessern, dass mehrere unterschiedlich elektrische Ströme gemessen werden können, indem mehrere voneinander getrennte Widerstandselemente vorgesehen sind, die jeweils einen elektrischen Strom führen können.

In den bevorzugten Ausführungsbeispielen der Erfindung weist die erfindungsgemäße Widerstandsordnung zwei voneinander getrennte Widerstandselemente auf, so dass gleichzeitig zwei elektrische Ströme gemessen werden können.

Es ist jedoch im Rahmen der Erfindung auch möglich, dass die Widerstandsanordnung mehr als zwei (z.B. vier) voneinander getrennte Widerstandselemente aufweist, um eine entsprechend größere Anzahl elektrischer Ströme messen zu können.

Die einzelnen Widerstandselemente können auch eine unterschiedliche Breite und/oder Dicke in Bezug auf die Stromflussrichtung aufweisen, um der jeweiligen Strombelastung gerecht zu werden.

Vorzugsweise sind die einzelnen Widerstandselemente hierbei unabhängig von der Anzahl der Widerstandselemente sternförmig miteinander verbunden und werden durch ein gemeinsames Anschlusselement elektrisch kontaktiert, während die weitere elektrische Kontaktierung der einzelnen Widerstandselemente durch jeweils ein separates Anschlusselement erfolgt.

Hierbei ist zu erwähnen, dass die Widerstandselemente einerseits und die Anschlusselemente andererseits ursprünglich getrennte Bauteile sind, die jedoch in der erfindungsgemäßen Widerstandsanordnung stoffschlüssig miteinander verbunden sind. Dies ermöglicht eine getrennte Optimierung der Anschlusselemente und der Widerstandselemente hinsichtlich ihrer Materialzusammensetzung auf ihre jeweilige Funktion hin.

Weiterhin ist die erfindungsgemäße Widerstandsanordnung gabelförmig, wobei die einzelnen Widerstandselemente nebeneinander und in einer Reihe liegen. Das gemeinsame Anschlusselement der Widerstandsanordnung liegt hierbei vorzugsweise auf einer Seite der Reihe von Widerstandselementen, während die anderen Anschlusselemente auf der gegenüberliegenden Seite der Reihe von Anschlusselementen liegen.

Im Betrieb werden die Widerstandselemente jeweils entlang einem Strompfad von einem elektrischen Strom durchflossen, wobei der Strompfad innerhalb der einzelnen Widerstandselemente vorzugsweise wesentlich kürzer ist als das erfindungsgemäße Widerstandselement selbst. Der elektrische Widerstand der Widerstandselemente wird also nicht durch eine mäanderförmige oder spiralförmige Führung der Widerstandselemente erhöht. Vielmehr sind die Widerstandselemente plattenförmig, was eine Beeinflussung des Widerstands und damit der Messgenauigkeit durch Formänderungen verhindert oder zumindest erschwert.

Die eigentliche Messung der über den einzelnen Widerstandselementen abfallenden elektrischen Spannung erfolgt vorzugsweise entsprechend der bekannten Vierleitertechnik durch Messanschlüsse, die elektrisch und mechanisch mit den einzelnen Anschlusselementen verbunden sind.

Vorzugsweise sind die einzelnen Messanschlüsse hierbei jeweils unmittelbar an den Grenzen zu den Widerstandselementen angeordnet, damit die Spannungsmessung nicht durch die innerhalb der Anschlusselemente abfallende elektrische Spannung verfälscht wird.

Darüber hinaus grenzen die Messanschlüsse innerhalb der Anschlusselemente der erfindungsgemäßen Widerstandsanordnung vorzugsweise unmittelbar an die Seitenkanten der Anschlusselemente an, was ebenfalls messtechnisch vorteilhaft ist.

In einem bevorzugten Ausführungsbeispiel der Erfindung ist zusätzlich eine Platine mit einer Messschaltung vorgesehen, wobei die Platine mit ihrer Hauptebene parallel zu den Hauptflächen der plattenförmigen Widerstandselementen angeordnet und mit diesen mechanisch und/oder elektrisch verbunden ist. Die erfindungsgemäße Widerstandsanordnung bildet hierbei also mit der Platine mit der Messschaltung eine bauliche Einheit, wobei der Einfluss von elektromagnetischen Einstreuungen und Thermospannungen durch einen geringen Abstand zwischen der Widerstandsanordnung und der Platine minimiert wird.

Die mechanische Verbindung der Platine mit der Widerstandsanordnung kann beispielsweise durch die Messanschlüsse erfolgen, indem die Platine mittels eines Lötverfahrens mit der Widerstandsanordnung verbunden wird.

Es ist jedoch alternativ auch möglich, dass die Platine durch einen Abstandshalter mechanisch mit der Widerstandsanordnung verbunden wird, wobei der Abstandshalter einen Ausgleich mechanisch-thermischer Dehnungen ermöglicht.

Darüber hinaus ist in dem gemeinsamen Anschlusselement der einzelnen Widerstandselemente vorzugsweise ein Durchbruch angeordnet, um die Stromverteilung in dem gemeinsamen Anschlusselement gezielt zu beeinflussen.

Bei dem Durchbruch kann es sich beispielsweise um eine rechteckige Aussparung handeln, wobei der Durchbruch vorzugsweise unmittelbar an den Messanschluss in dem gemeinsamen Anschlusselement angrenzt.

Bei einer gabelförmigen Gestaltung der erfindungsgemäßen Widerstandsanordnung wird der Durchbruch zur Beeinflussung der Stromverteilung vorzugsweise mittig zwischen den beiden Widerstandselementen angeordnet.

Die mechanische Verbindung zwischen den Anschlusselementen und den Widerstandselementen erfolgt durch eine Verschweißung.

Weiterhin ist zu erwähnen, dass die Anschlusselemente zur Stromeinspeisung bzw. Stromabführung vorzugsweise aus Kupfer oder einer ähnlich leitfähigen Kupferverbindung bestehen, während die niederohmigen Widerstandselemente vorzugsweise aus einer CuMnNi-Verbindung (z.B. Manganin®) bestehen. Die Anschlusselemente und die Widerstandselemente bestehen bei der erfindungsgemäßen Widerstandsanordnung also aus unterschiedlichen Materialien, die vorzugsweise einen verschiedenen spezifischen elektrischen Widerstand aufweisen.

Zur niederohmigen Strommessung eignen sich vorzugsweise Widerstände, die im Bereich zwischen 1µΩ und 1mΩ liegen. Die Erfindung ist jedoch hinsichtlich des Widerstandswertes der Widerstandselemente nicht auf den vorstehend genannten Wertebereich beschränkt.

Darüber hinaus umfasst die Erfindung auch ein vorteilhaftes Herstellungsverfahren für eine erfindungsgemäße Widerstandsanordnung, das im Folgenden kurz beschrieben wird.

Das erfindungsgemäße Herstellungsverfahren sieht zunächst in bekannter Weise vor, dass ein langgestrecktes Band aus einem Widerstandsmaterial jeweils an seinen Längskanten mit jeweils einem langgestreckten Band aus einem elektrisch leitfähigen Material mechanisch und elektrisch verbunden wird, wobei die Verbindung durch eine Verschweißung erfolgt.

Anschließend werden die miteinander verbundenen Bänder dann entlang mehrerer quer verlaufender Bänder in mehrere Widerstandsanordnungen getrennt.

Von besonderer Bedeutung ist hierbei, dass in den einzelnen Widerstandsanordnungen jeweils zwischen zwei benachbarten Trennlinien quer verlaufende Aussparungen erzeugt werden, wobei sich die Aussparungen von einer Längskante der Widerstandsanordnung ausgehend nach innen mindestens bis zu dem Band aus dem Widerstandsmaterial erstrecken, um jeweils zwei voneinander getrennte Anschlusselemente zu bilden.

Die Erzeugung der Aussparungen zur Ausgestaltung der voneinander getrennten Elemente kann wahlweise vor der Trennung der einzelnen Widerstandsanordnungen oder nach deren Trennung erfolgen.

In einem bevorzugten Ausführungsbeispiel der Erfindung erstrecken sich diese quer verlaufenden Aussparungen nach innen sogar bis zu dem gegenüberliegenden Band aus dem elektrisch leitfähigen Material, um jeweils zwei voneinander getrennte Widerstandselemente zu bilden. In diesem Ausführungsbeispiel der Erfindung sind die beiden Widerstandselemente einer Widerstandsanordnung also vollständig räumlich voneinander getrennt und lediglich durch das gemeinsame Anschlusselement elektrisch miteinander verbunden.

Die Trennlinien für die Trennung der einzelnen Widerstandsanordnungen und die Aussparungen für die Trennung der einzelnen Anschlusselemente bzw. Widerstandselemente in den einzelnen Widerstandsanordnungen werden vorzugsweise ausgestanzt, jedoch ist es grundsätzlich auch möglich, hierzu andere Fertigungsverfahren einzusetzen.

Schließlich umfasst die Erfindung auch eine Messschaltung mit mindestens einer erfindungsgemäßen Widerstandsanordnung, wobei sich diese Messschaltung insbesondere zur Strommessung in einem Kraftfahrzeug-Bordnetz eignet.

Die erfindungsgemäße Widerstandsanordnung kann hierbei wahlweise masseseitig ("low side") oder spannungsseitig ("high side") geschaltet sein, jedoch ist es auch möglich, sowohl masseseitig als auch spannungsseitig jeweils eine Widerstandsanordnung vorzusehen.

Bei einem Einsatz der erfindungsgemäßen Widerstandsanordnung zur Strommessung in einem Kraftfahrzeug-Bordnetz kann ein Widerstandselement beispielsweise in einem Batteriestromkreis angeordnet sein, während ein anderes Widerstandselement beispielsweise in einem Generatorstromkreis angeordnet sein kann. Auf diese Weise kann sowohl der Batteriestrom als auch der Generatorstrom direkt gemessen werden, während der Fahrzeugstrom aus den beiden Messwerten abgeleitet werden kann.

Es ist jedoch alternativ auch möglich, dass ein Widerstandselement in dem Batteriestromkreis des Kraftfahrzeug-Bordnetzes angeordnet ist, während das andere Widerstandselement den Fahrzeugstrom misst und mit den einzelnen Verbrauchern verbunden ist. In diesem Fall ermöglicht die erfindungsgemäße Widerstandsanordnung eine direkte Messung des Batteriestroms und des Fahrzeugstroms, während der Generatorstrom aus diesen beiden Messwerten abgeleitet werden kann.

In jedem Fall ermöglicht die Erfindung auf einfache Weise eine zuverlässige Messwerterfassung für kombiniertes elektronisches Batterie- und Powermanagement, das zur Sicherstellung der Stromversorgung in Bordnetzen insbesondere von Kraftfahrzeugen mit ständig zunehmender Zahl elektrischer Verbraucher immer wichtiger wird.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine Aufsicht auf eine erfindungsgemäße Widerstandsanordnung,
- Figur 2: eine Aufsicht auf ein alternatives Ausführungsbeispiel einer erfindungsgemäßen Widerstandsanordnung,
- Figur 3: eine Seitenansicht der Widerstandsanordnung aus Figur 1 mit einer Platine mit einer Messschaltung,
- Figur 4: eine Aufsicht auf mehrere erfindungsgemäße Anordnungen im vorfabrizierten Zustand während der Fertigung,
- Figur 5: eine erfindungsgemäße Messschaltung mit zwei erfindungsgemäßen Widerstandsanordnungen,
- Figur 6: ein alternatives Ausführungsbeispiel einer erfindungsgemäßen Messschaltung,
- Figur 7a bis 7d: vereinfachte Ausführungsbeispiele von erfindungsgemäßen Messschaltungen sowie
- Figur 8: ein weiteres Ausführungsbeispiel einer erfindungsgemäßen Widerstandsanordnung mit vier Widerstandselementen.

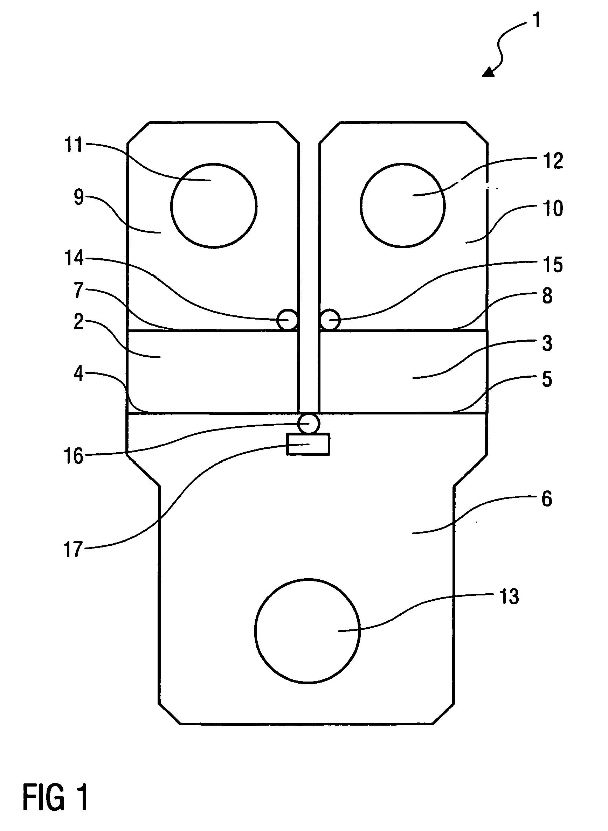

Die Aufsichtsdarstellung in Figur 1 zeigt eine erfindungsgemäße Widerstandsanordnung 1, die beispielsweise in einem Kraftfahrzeug-Bordnetz zur Messung des Generatorstroms und des Batteriestroms eingesetzt werden kann, wie später noch detailliert beschrieben wird.

Hierzu weist die Widerstandsanordnung 1 zwei räumlich voneinander getrennte Widerstandselemente 2, 3 auf, die jeweils aus einer Kupferlegierung (z.B. Manganin®) bestehen und einen Widerstand von z.B. 100 µΩ aufweisen.

Die beiden Widerstandselemente 2, 3 sind durch jeweils eine Schweißnaht 4, 5 mit einem gemeinsamen Anschlusselement 6 verbunden, das aus Kupfer besteht und zur Stromeinspeisung oder zur Stromabfuhr dient.

Weiterhin sind die beiden Widerstandselemente 2, 3 über jeweils eine weitere Schweißnaht 7, 8 mit jeweils einem separaten Anschlusselement 9 bzw. 10 verbunden, wobei die beiden Anschlusselemente 9, 10 eine separate Stromeinspeisung bzw. Stromabfuhr ermöglichen.

Zur Kontaktierung der Anschlusselemente 6, 9, 10 weisen diese jeweils eine Stromanschluss-Bohrung 11, 12 bzw. 13 auf.

Die eigentliche Strommessung erfolgt hierbei entsprechend der an sich bekannten Vierleitertechnik durch Messanschlüsse 14, 15, 16, die jeweils mit einem der Anschlusselemente 6, 9 bzw. 10 verbunden sind. Durch eine Messung der elektrischen Spannung zwischen den beiden Messanschlüssen 14 und 16 kann beispielsweise der durch das Widerstandselement 2 fließende elektrische Strom ermittelt werden, während die elektrische Spannung zwischen den Messanschlüssen 15 und 16 den elektrischen Strom durch das Widerstandselement 3 wiedergibt.

Die Messanschlüsse 14, 15, 16 sind hierbei jeweils unmittelbar an die Widerstandselemente 2, 3 angrenzend angeordnet, um Messfehler durch die innerhalb der Anschlusselemente 6, 9, 10 abfallende elektrische Spannung zu verhindern.

Darüber hinaus sind die Messanschlüsse 14, 15, 16 darstellungsgemäß unmittelbar an den Seitenkanten der Anschlusselemente 6, 9, 10 angeordnet, was messtechnisch ebenfalls vorteilhaft ist.

Ferner weist die Widerstandsanordnung 1 in dem Anschlusselement 6 einen Durchbruch 17 auf, der unmittelbar an den Messanschluss 16 angrenzt und die Stromverteilung in dem Anschlusselement 6 gezielt beeinflusst.

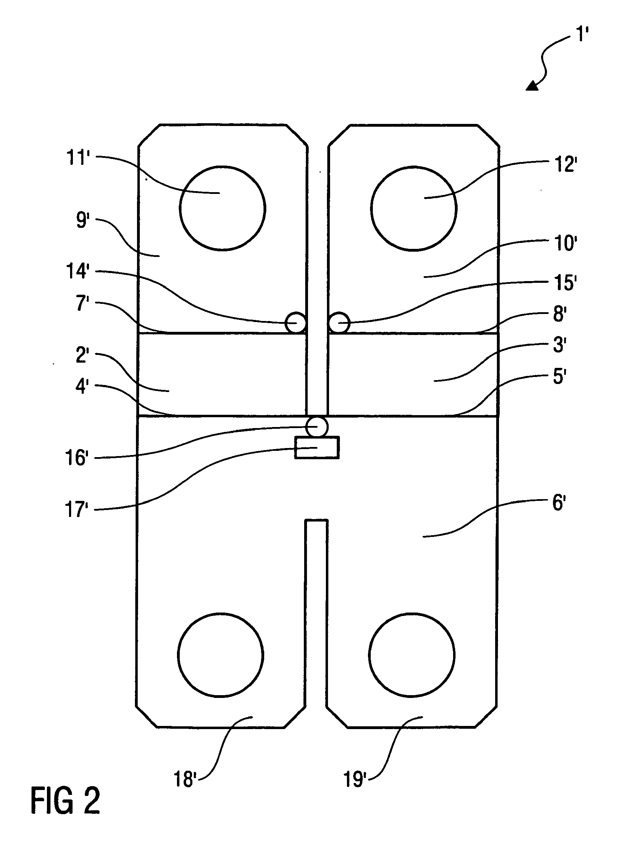

Das in Figur 2 dargestellte alternative Ausführungsbeispiel einer erfindungsgemäßen Widerstandsanordnung 1' stimmt weitgehend mit dem vorstehend beschriebenen und in Figur 1 dargestellten Ausführungsbeispiel der Widerstandsanordnung 1 überein, so dass im Folgenden zur Vermeidung von Wiederholungen weitgehend auf die vorstehende Beschreibung zu Figur 1 verwiesen wird und für entsprechende Teile dieselben Bezugszeichen verwendet werden, die lediglich zur Unterscheidung durch einen Apostroph gekennzeichnet sind.

Eine Besonderheit dieses Ausführungsbeispiels besteht darin, dass das gemeinsame Anschlusselement 6' zwei getrennte Kontaktzungen 18', 19' zur Stromabführung aufweist.

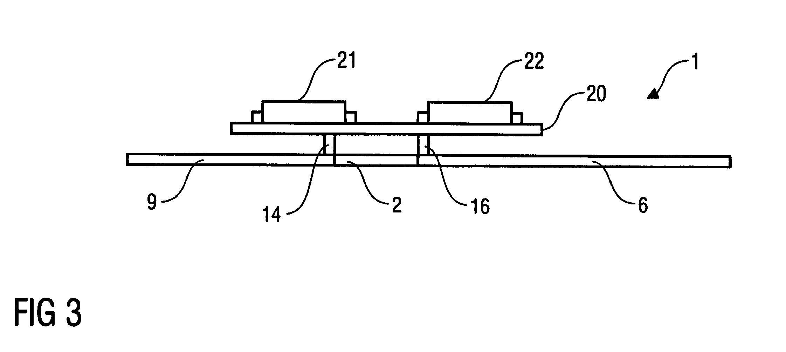

Aus der Seitenansicht in Figur 3 ist weiterhin ersichtlich, dass die in Figur 1 gezeigte Widerstandsanordnung 1 mit einer Platine 20 verbunden ist, wobei die Platine 20 eine Messschaltung in SMD-Bauweise trägt. Zur Vereinfachung sind hierbei lediglich beispielhaft zwei SMD-Bauelemente 21, 22 der Messschaltung dargestellt.

Die mechanische und elektrische Verbindung der Platine 20 mit der Widerstandsanordnung 1 erfolgt hierbei durch die Messanschlüsse 14, 15 und 16, wobei der geringe Abstand zwischen der Platine 20 und der Widerstandsanordnung 1 dafür sorgt, dass der Einfluss von elektromagnetischen Einstreuungen und Thermospannungen gering bleibt.

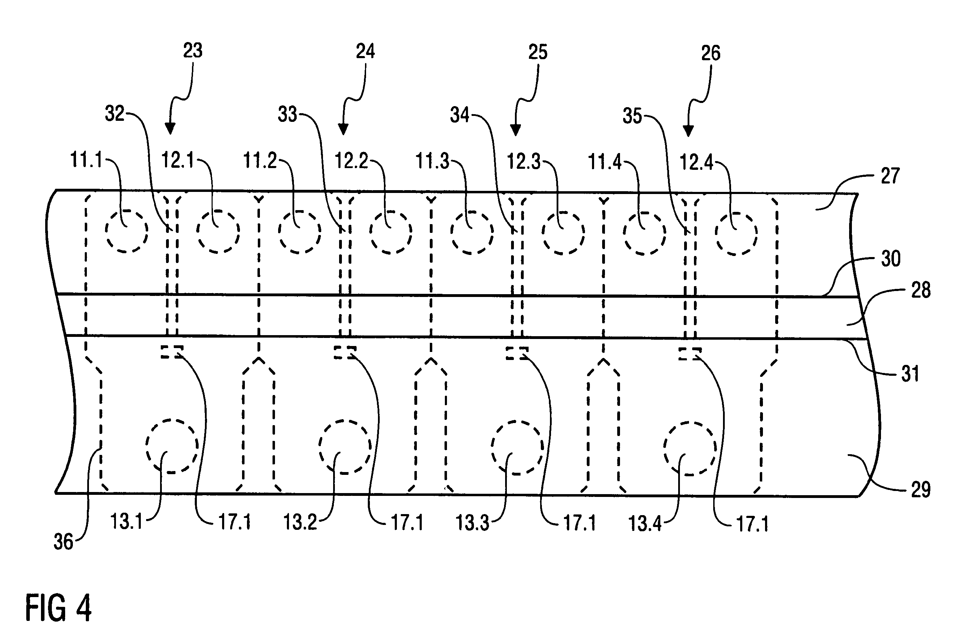

Figur 4 zeigt schließlich eine Aufsicht auf mehrere Widerstandsanordnungen 23-26 der in Figur 1 gezeigten Art im vorfabrizierten Zustand.

Bei der Herstellung der Widerstandsanordnungen 23-26 werden zunächst drei langgestreckte Bänder 27, 28, 29 entlang ihrer Längskanten durch Schweißnähte 30, 31 miteinander verbunden, wobei die beiden außen liegenden Bänder 27, 29 aus Kupfer bestehen, während das mittlere Band 28 aus der erwähnten Kupferlegierung besteht und später die Widerstandselemente 2, 3 der einzelnen Widerstandsanordnungen 23-26 bildet.

Nach dem Zusammenschweißen der Bänder 27-29 werden in den noch zusammenhängenden Widerstandsanordnungen 23-26 quer verlaufende Aussparungen 32-35 ausgestanzt, die sich von der Seitenkante des Bandes 27 ausgehend nach innen bis zu der Schweißnaht 31 erstrecken, so dass die Aussparungen 32-35 in den Widerstandsanordnungen 23-26 die Anschlusselemente 9 und 10 sowie die Widerstandsanordnungen 2 und 3 voneinander trennen.

Darüber hinaus werden in den einzelnen Widerstandsanordnungen 23-26 Aussparungen 11.1-11.4, 12.1-12.4 und 13.1-13.4 ausgestanzt, die zum Anschluss separater Leitungen dienen.

Ferner werden noch Durchbrüche 17.1-17.4 in den einzelnen Widerstandsanordnungen 23-26 ausgestanzt, wobei die Durchbrüche 17.1-17.4 der Beeinflussung der Stromverteilung in den Widerstandsanordnungen dienen.

Schließlich werden die einzelnen Widerstandsanordnungen dann entlang vorgegebener Trennlinien 36 getrennt, um anschließend die in Figur 3 gezeigte Platine 20 mit der Messschaltung montieren zu können.

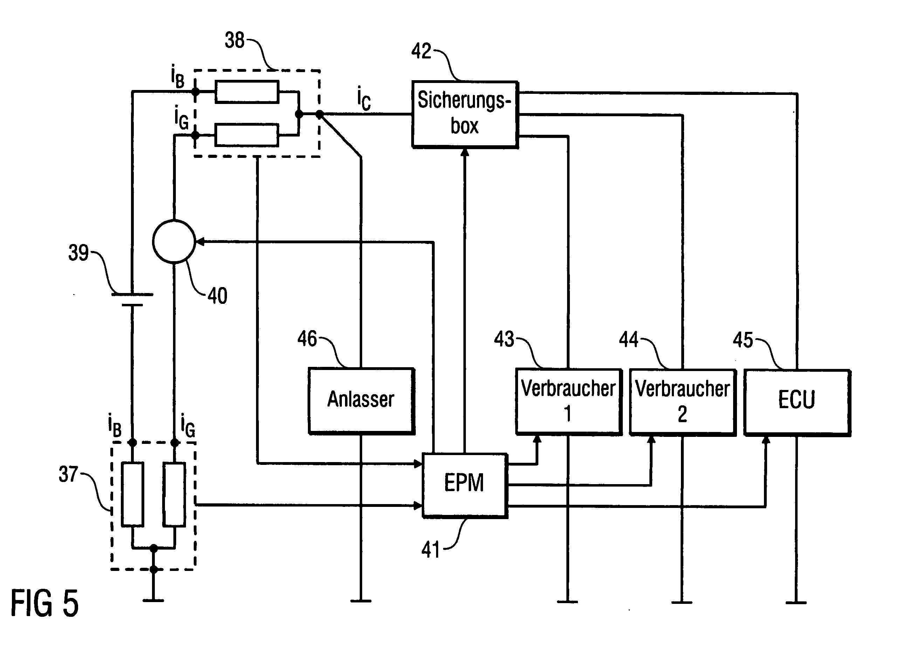

Figur 5 zeigt schließlich eine Messschaltung, die mittels zweier erfindungsgemäßer Widerstandsanordnungen 37, 38 zur Strommessung in einem Kraftfahrzeug-Bordnetz verwendet wird.

Die Widerstandsanordnung 37 ist hierbei masseseitig ("low side") angeordnet, wobei ein Widerstandselement der Widerstandsanordnung 37 in dem Stromkreis einer Batterie 39 angeordnet ist, während das andere Widerstandselement der Widerstandsanordnung 37 in dem Stromkreis eines Generators 40 angeordnet ist. Die Widerstandsanordnung 37 ermöglicht also eine Messung sowohl eines Batteriestroms i_{B} als auch eines Generatorstroms i_{G}, wobei sich ein Fahrzeugstrom i_{C} als negative Summe der beiden Teilströme i_{B} und i_{G} ergibt.

Die andere Widerstandsanordnung 38 ermöglicht ebenfalls eine Messung der Teilströme i_{B} und i_{G}, da ein Element der Widerstandsordnung 38 in dem Stromkreis der Batterie 39 angeordnet ist, während das andere Widerstandselement der Widerstandsanordnung 38 in dem Stromkreis des Generators 40 angeordnet ist.

Die an den beiden Widerstandsanordnungen 37, 88 abgegriffenen Ströme werden (hier nur vereinfacht dargestellt) einer Überwachungseinheit 41 (EPM - Electronic Power Management), zugeführt, die in Abhängigkeit von den Messwerten eine Sicherungsbox 42, mehrere Verbraucher 43, 44 sowie eine elektronische Steuereinheit 45 (ECU - Electronic Control Unit) eines Kraftfahrzeugs ansteuert.

Ferner ist noch ein Anlasser 46 dargestellt, der mit dem Summationspunkt der Widerstandsanordnung 38 verbunden ist.

Die erfindungsgemäßen Widerstandsanordnungen 37, 38 ermöglichen hierbei vorteilhaft die Messung des Batteriestroms i_{B} und des Generatorstroms i_{G}, wobei daraus der Fahrzeugstrom i_{C} ableitbar ist.

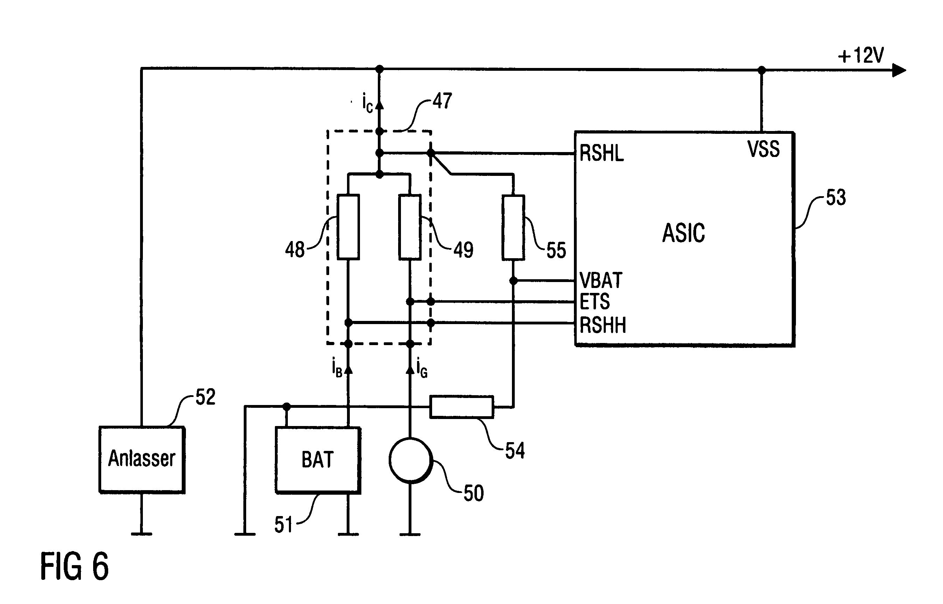

Das Schaltbild in Figur 6 zeigt ein alternatives Ausführungsbeispiel einer erfindungsgemäßen Messschaltung, bei dem zur Strommessung ebenfalls eine erfindungsgemäße Widerstandsanordnung 47 mit zwei Widerstandselementen 48, 49 eingesetzt wird.

Das Widerstandselement 49 ist hierbei in einem Schaltungszweig mit einem Generator 50 angeordnet und ermöglicht deshalb eine Messung eines Generatorstroms i_{G}.

Das andere Widerstandselement 48 ist dagegen in einem Schaltungszweig gemeinsam mit einer Batterie 51 angeordnet und ermöglicht somit die Messung eines Batteriestroms i_{B}.

Bei diesem Ausführungsbeispiel ist die erfindungsgemäße Widerstandsanordnung 47 in Bezug auf den Generator 50 und die Batterie 51 spannungsseitig ("high side") angeordnet.

An dem gemeinsamen Anschlusselement der erfindungsgemäßen Widerstandsanordnung 47 sind ein Anlasser 52 sowie mehrere elektrische Verbraucher angeschlossen, wobei die Verbraucher zur Vereinfachung nicht dargestellt sind.

Die eigentliche Strommessung erfolgt hierbei durch eine integrierte Schaltung 53 (ASIC - Application Specific Integrated Circuit), die beispielsweise in DE 102 37 126.1 detailliert beschrieben ist. Der Inhalt dieser Druckschrift ist deshalb der vorliegenden Beschreibung hinsichtlich des Aufbaus und der Funktionsweise der integrierten Schaltung 53 in vollem Umfang zuzurechnen, so dass auf eine detaillierte Beschreibung der integrierten Schaltung 53 verzichtet werden kann.

Es ist jedoch zu erwähnen, dass die integrierte Schaltung 53 einen Messeingang VBAT aufweist, an den ein Spannungsteiler angeschlossen ist, der aus zwei Widerständen 54, 55 besteht, wobei der Widerstand 54 mit Masse verbunden ist, während der Widerstand 55 spannungsseitig mit der Bordnetzspannung verbunden ist.

Weiterhin weist die integrierte Schaltung 53 einen spannungsseitigen Spannungsabgriff RSHL auf, der an das gemeinsame Anschlusselement der Widerstandsanordnung 47 angeschlossen ist.

Die beiden anderen Anschlusselemente der Widerstandsanordnung 47 sind dagegen getrennt mit jeweils einem weiteren Messeingang ETS bzw. RSHH der integrierten Schaltung 53 verbunden.

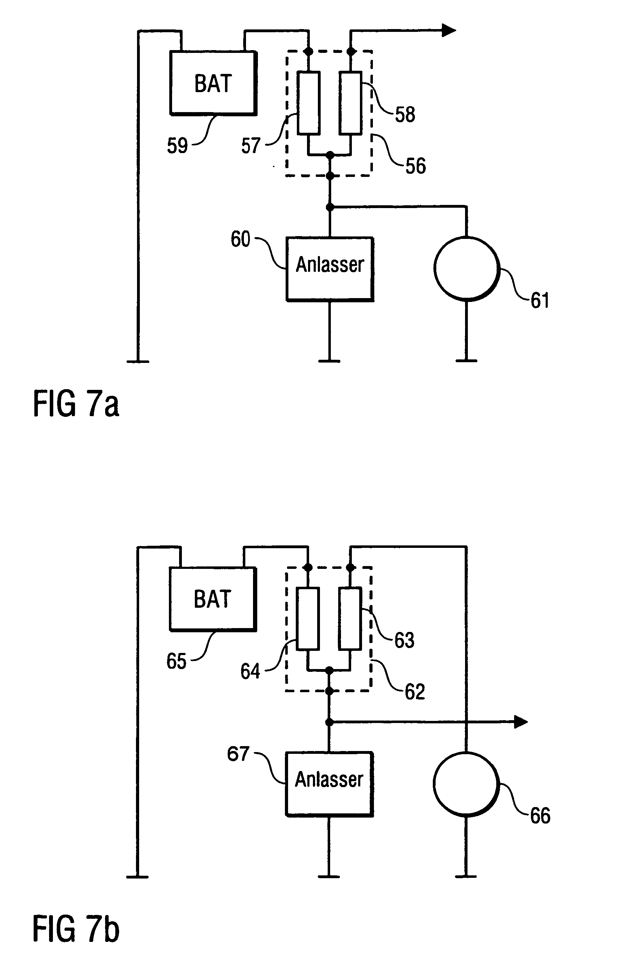

Schließlich zeigen die Figuren 7a bis 7d einfache Ausführungsbeispiele alternativer Abwandlungen erfindungsgemäßer Messschaltungen, wobei im folgenden zunächst die Messschaltung in Figur 7a beschrieben wird.

Hierbei wird ebenfalls eine erfindungsgemäße Widerstandsanordnung 56 mit zwei Widerstandselementen 57, 58 eingesetzt, wobei das Widerstandselement 57 gemeinsam mit einer Batterie 59 in einem Schaltungszweig angeordnet ist.

Das Widerstandselement 58 der Widerstandsanordndung 56 ist dagegen in einem anderen Schaltungszweig angeordnet, über den sämtliche Verbraucher des Kfz-Bordnetzes mit Strom versorgt werden.

An das gemeinsame Anschlusselement der Widerstandsanordnung 56 sind hierbei ein Anlasser 60 und ein Generator 61 angeschlossen.

In diesem Ausführungsbeispiel ist die Widerstandsanordnung 56 also ebenfalls spannungsseitig angeordnet.

Das in Figur 7b dargestellte Ausführungsbeispiel einer erfindungsgemäßen Messschaltung weist ebenfalls eine erfindungsgemäße Widerstandsanordnung 62 mit zwei Widerstandselementen 63, 64 auf, wobei das Widerstandselement 64 wiederum gemeinsam mit einer Batterie 65 in einem Schaltungszweig angeordnet ist.

Das andere Widerstandselement 63 ist dagegen in einem Schaltungszweig gemeinsam mit einem Generator 66 angeordnet.

In diesem Ausführungsbeispiel können also der Batteriestrom und der Generatorstrom direkt gemessen werden, während der Fahrzeugstrom aus diesen beiden Messwerten abgeleitet wird.

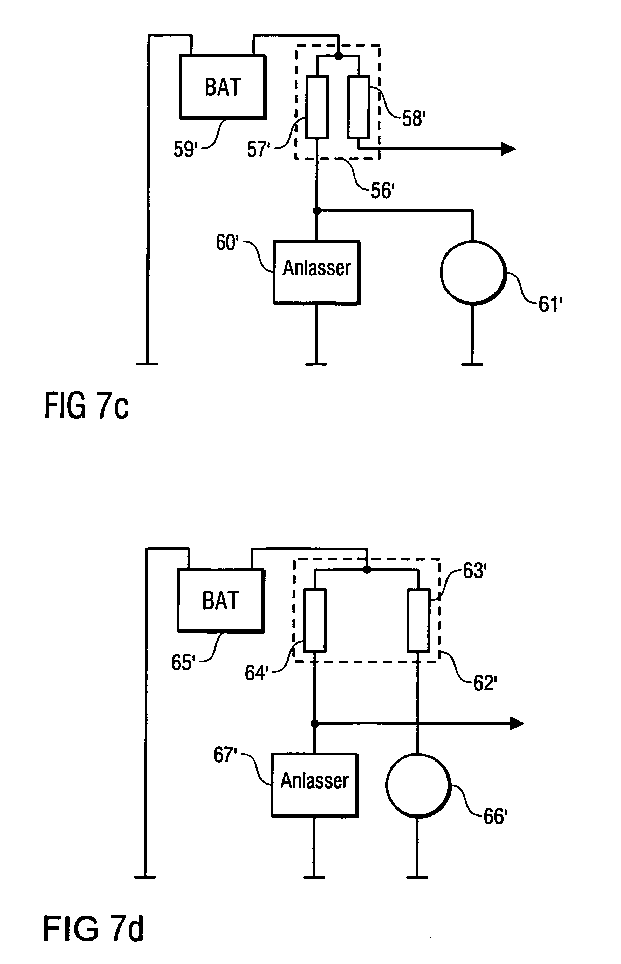

An dem gemeinsamen Anschluss der erfindungsgemäßen Widerstandsanordnung 62 ist hierbei ein Anlasser 67 und ein Abgriff zur Speisung des Kfz-Bordnetzes angeschlossen. Die Ausführungsbeispiele in den Figuren 7c und 7d sind ähnlich zu den Ausführungsbeispielen in den Figuren 7a und 7b, so dass im folgenden zur Vermeidung von Wiederholungen auf die vorstehenden Beschreibung verwiesen wird und für übereinstimmende Bauteile dieselben Bezugszeichen verwendet werden, die lediglich zur Unterscheidung durch ein Apostroph gekennzeichnet sind.

Eine Besonderheit des Ausführungsbeispiels gemäß Figur 7c besteht darin, dass an das gemeinsame Anschlusselement der Widerstandsanordnung 56' ein Schaltungszweig angeschlossen ist, in dem sich die Batterie 59' befindet.

Eine der beiden getrennten Anschlusselementen der Widerstandsanordnung 56' ist dagegen mit einem Schaltungszweig verbunden, in dem eine Parallelschaltung aus dem Anlasser 60' und dem Generator 61' angeordnet ist.

Das andere Anschlusselement der beiden getrennten Anschlusselemente der Widerstandsanordnung 56' ist dagegen mit einem Schaltungszweig verbunden, in dem der Fahrzeugstrom fliesst.

Bei dem Ausführungsbeispiels gemäß Figur 7d ist an das gemeinsame Anschlusselement der Widerstandsanordnung 62' ebenfalls ein Schaltungszweig angeschlossen ist, in dem sich die Batterie 65' befindet.

Die beiden getrennten Anschlusselemente der Widerstandsanordnung 62' sind dagegen mit zwei Schaltungszweigen verbunden, in denen der Anlasser 67' bzw. der Generator 66' angeordnet ist.

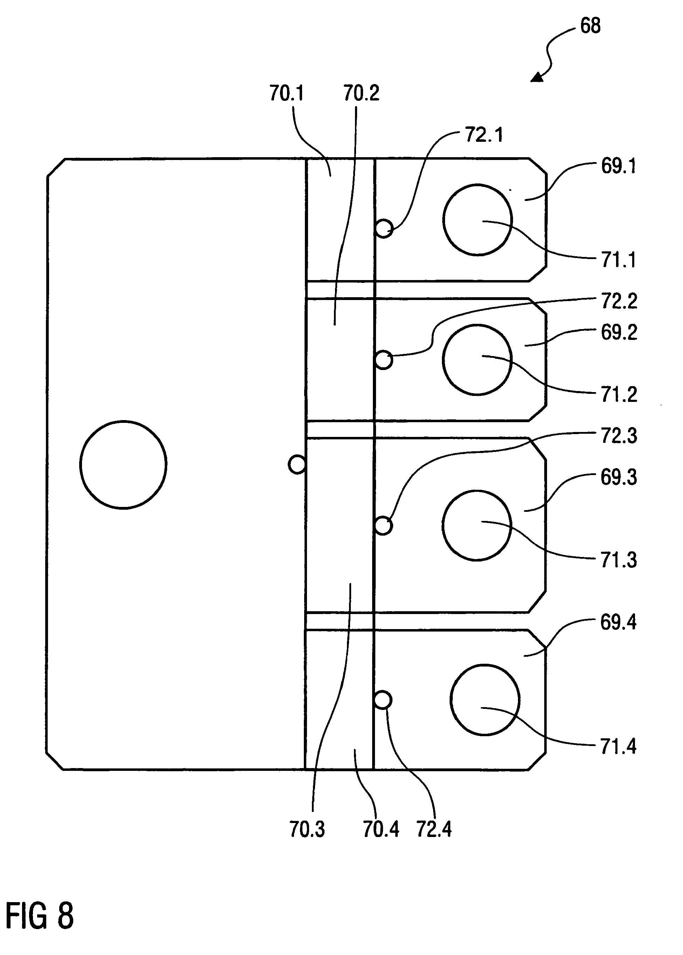

Schließlich zeigt Figur 8 ein Ausführungsbeispiel einer Widerstandsanordnung 68, das weitgehend mit dem in Figur 1 dargestellten Ausführungsbeispiel übereinstimmt, so dass im folgenden zur Vermeidung von Wiederholungen auf die vorstehende Beschreibung verwiesen wird.

Eine Besonderheit der Widerstandsanordnung 68 besteht darin, dass insgesamt vier Anschlusselemente 69.1-69.4 und entsprechend auch vier Widerstandselemente 70.1-70.4 vorgesehen sind.

In jedem der vier Anschlusselemente 69.1-69.4 ist hierbei wiederum jeweils eine Stromanschluss-Bohrung 71.1-71.4 angeordnet.

Schließlich ist auch an jedem der Anschlusselemente 69.1-69.4 jeweils ein Messanschluss 72.1-72.4 angebracht.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen, der durch die unabhängigen Ansprüche 1, 12 und 17 festgelegt ist.

## Patentansprüche

1. Widerstandsanordnung (1, 37, 38), insbesondere zur Messung von Batteriestrom und Generatorstrom in einem KFZ-Bordnetz, mit
a) zwei voneinander getrennten plattenförmigen Anschlusselementen (6, 9),
b) einem zwischen den beiden Anschlusselementen (6, 9) angeordneten und mit diesen elektrisch und mechanisch verbundenen ersten Widerstandselement (2),
c) einem weiteren Anschlusselement (10),
d) mindestens einem von dem ersten Widerstandselement (2) getrennten weiteren Widerstandselement (3), das zwischen einem der beiden Anschlusselemente (6, 9) des ersten Widerstandselements (2) und dem weiteren Anschlusselement (10) angeordnet und mit diesen Anschlusselementen (6, 10) elektrisch und mechanisch verbunden ist,
**dadurch gekennzeichnet**,
e) dass die Widerstandselemente (2, 3) plattenförmig sind,
f) dass die Anschlusselemente (6, 9, 10) einerseits und die Widerstandselemente (2, 3) andererseits aus unterschiedlichen Materialien bestehen,
g) dass die Widerstandsanordnung (1, 37, 38) gabelförmig ist, wobei die einzelnen Widerstandselemente (2, 3) nebeneinander in einer Reihe liegen,
h) dass das gemeinsame Anschlusselement (6) auf einer Seite der Reihe von Widerstandselementen (2, 3) liegt, während die anderen Anschlusselemente (9, 10) auf der anderen Seite der Reihe von Widerstandselementen (2, 3) liegen,
i) dass die Anschlusselemente (6, 9, 10) mit den Widerstandselementen (2, 3) verschweißt sind.

2. Widerstandsanordnung (1, 37, 38) nach Anspruch 1, **dadurch gekennzeichnet, dass** zur Erfassung der über den Widerstandselementen (2, 3) abfallenden elektrischen Spannung Messanschlüsse (14-16) vorgesehen sind, die elektrisch und mechanisch mit den einzelnen Anschlusselementen (6, 9, 10) verbunden sind.

3. Widerstandsanordnung (1, 37, 38) nach Anspruch 2, **dadurch gekennzeichnet, dass** die Messanschlüsse (14-16) jeweils unmittelbar an die Widerstandselemente (2, 3) und/oder an Seitenkanten der Anschlusselemente (6, 9, 10) angrenzend angeordnet sind.

4. Widerstandsanordnung (1, 37, 38) nach einem der vorhergehenden Ansprüche, **gekennzeichnet durch** eine Platine (20) mit einer Messschaltung, wobei die Platine (20) parallel zu den plattenförmigen Widerstandselementen (2, 3) angeordnet und mit diesen elektrisch verbunden ist.

5. Widerstandsanordnung (1, 37, 38) nach Anspruch 4, **dadurch gekennzeichnet, dass** die Platine (20) mit der Messschaltung durch die Messanschlüsse (14-16) mechanisch mit den Anschlusselementen (6, 9, 10) verbunden ist.

6. Widerstandsanordnung (1, 37, 38) nach Anspruch 4, **dadurch gekennzeichnet, dass** die Platine (20) mit der Messschaltung durch einen Abstandshalter mechanisch mit den Anschlusselementen (6, 9, 10) und/oder den Widerstandselementen (2, 3) verbunden ist.

7. Widerstandsanordnung (1, 37, 38) nach einem der vorhergehenden Ansprüche, **dadurch gekennzeichnet, dass** in dem gemeinsamen Anschlusselement (6) der Widerstandselemente (2, 3) ein Durchbruch (17, 17.1-17.4) zur Beeinflussung des Stromverteilung angeordnet ist.

8. Widerstandsanordnung (1, 37, 38) nach Anspruch 7, **dadurch gekennzeichnet, dass** der Durchbruch (17, 17.1-17.4) mittig zwischen den beiden Widerstandselementen (2, 3) angeordnet ist.

9. Widerstandsanordnung (1, 37, 38) nach einem der vorhergehenden Ansprüche, **dadurch gekennzeichnet, dass** die Anschlusselemente (6, 9, 10) aus Kupfer oder einer Kupferverbindung bestehen.

10. Widerstandsanordnung (1, 37, 38) nach einem der vorhergehenden Ansprüche, **dadurch gekennzeichnet, dass** die Widerstandselemente (2, 3) aus Manganin® bestehen.

11. Widerstandsanordnung (1, 37, 38) nach einem der vorhergehenden Ansprüche, **dadurch gekennzeichnet, dass** das gemeinsame Anschlusselement (6') der beiden Widerstandselemente (2') zur Stromabführung zwei Anschlusskontakte (18') aufweist.

12. Herstellungsverfahren für Widerstandsanordnungen (1, 37, 38) mit den folgenden Schritten:
- Mechanische und elektrische Verbindung eines langgestreckten Bandes (28) aus einem Widerstandsmaterial jeweils an dessen Längskanten mit jeweils einem langgestreckten Band (27, 29) aus einem elektrisch leitfähigen Material,
- Trennung der miteinander verbundenen Bänder (27-29) in mehrere Widerstandsanordnungen (1, 37, 38) entlang mehrerer quer verlaufender Trennlinien (36),
**dadurch gekennzeichnet, dass**
in den einzelnen Widerstandsanordnungen (1, 37, 38) jeweils zwischen zwei benachbarten Trennlinien (36) quer verlaufende Aussparungen (32-35) erzeugt werden,
wobei sich die Aussparungen (32-35) von einer Längskante der Widerstandsanordnungen (1, 37, 38) ausgehend nach innen mindestens bis zu dem Band (28) aus dem Widerstandsmaterial erstrecken, um jeweils zwei voneinander getrennte Anschlusselemente (9, 10) zu bilden.

13. Herstellungsverfahren nach Anspruch 12, **dadurch gekennzeichnet, dass** sich die quer verlaufenden Aussparungen (32-35) nach innen mindestens bis zu dem gegenüber liegenden Band (29) aus dem elektrisch leitfähigen Material erstrecken, um jeweils zwei voneinander getrennte Widerstandselemente (2, 3) zu bilden.

14. Herstellungsverfahren nach Anspruch 12 oder 13, **dadurch gekennzeichnet, dass** die Aussparungen (32-35) und/oder die Trennlinien (36) gestanzt werden.

15. Herstellungsverfahren nach einem der Ansprüche 12 bis 14, **dadurch gekennzeichnet, dass** die Bänder (27-29) miteinander verschweißt werden.

16. Herstellungsverfahren nach einem der Ansprüche 13 bis 15, **dadurch gekennzeichnet, dass** die einzelnen Widerstandsanordnungen (1, 37, 38) jeweils mit einer integrierten Messschaltung elektrisch und/oder mechanisch verbunden werden.

17. Messschaltung, insbesondere zur Messung von Batteriestrom und Generatorstrom in einem KFZ-Bordnetz, mit
- einem ersten Widerstandselement (48, 57, 64), das in einem ersten Schaltungszweig angeordnet ist,
- einem ersten Spannungsabgriff zur Messung der über dem ersten Widerstandselement (48, 57, 64) abfallenden elektrischen Spannung,
- einem zweiten Widerstandselement (49, 58, 63), das in einem zweiten Schaltungszweig angeordnet ist, sowie mit
- einem zweiten Spannungsabgriff zur Messung der über dem zweiten Widerstandselement (49, 58, 63) abfallenden elektrischen Spannung,
- wobei die beiden Widerstandselemente (48, 49, 57, 58, 63, 64) gemeinsam in einer Widerstandsanordnung (47, 56, 62) angeordnet und mechanisch miteinander verbunden sind
**dadurch gekennzeichnet, dass**
die Widerstandsanordnung (1, 2, 37, 38, 47, 56, 62) gemäß einem der Ansprüche 1 bis 11 ausgebildet ist.

18. Messschaltung nach Anspruch 17, **dadurch gekennzeichnet, dass** die beiden Widerstandselemente (48, 49, 57, 58, 63, 64) ein gemeinsames Anschlusselement zur Stromeinspeisung und/oder zur Stromabfuhr aufweisen.

19. Messschaltung nach Anspruch 18, **dadurch gekennzeichnet, dass** an das gemeinsame Anschlusselement ein dritter Schaltungszweig mit einem Anlasser (52, 60, 67) angeschlossen ist.

20. Messschaltung nach einem der Ansprüche 17 bis 19, **dadurch gekennzeichnet, dass** in dem ersten Schaltungszweig eine Batterie (51, 59, 65) und in dem zweiten Schaltungszweig mindestens ein Verbraucher angeordnet ist.

21. Messschaltung nach einem der Ansprüche 17 bis 20, **dadurch gekennzeichnet, dass** in dem ersten Schaltungszweig eine Batterie (51, 59, 65) und in dem zweiten Schaltungszweig ein Generator (50, 66) angeordnet ist.

22. Messschaltung nach Anspruch 21, **dadurch gekennzeichnet, dass** an das gemeinsame Anschlusselement ein dritter Schaltungszweig mit einer Batterie (59') angeschlossen ist.

23. Messschaltung nach Anspruch 22, **dadurch gekennzeichnet, dass** in dem ersten Schaltungszweig ein Anlasser (67') und in dem zweiten Schaltungszweig ein Generator (66') angeordnet ist.

24. Messschaltung nach Anspruch 22, **dadurch gekennzeichnet, dass** in dem ersten Schaltungszweig eine Parallelschaltung aus einem Anlasser (60') und einem Generator (61') angeordnet ist, während in dem zweiten Schaltungszweig mindestens ein Verbraucher angeordnet ist.

25. Messschaltung nach einem der Ansprüche 17 bis 24, **dadurch gekennzeichnet, dass** die Widerstandsanordnung (1, 37, 38) masseseitig geschaltet ist.

26. Messschaltung nach einem der Ansprüche 17 bis 25, **dadurch gekennzeichnet, dass** die Widerstandsanordnung (1, 37, 38, 47, 56, 62) spannungsseitig geschaltet ist.

## Claims

1. Resistance arrangement (1, 37, 38), especially for measurement of the battery current and generator current in a vehicle electrical system, with
a) two plate-shaped connection elements (6, 9), separated from each other,
b) a first resistance element (2) arranged between the two connection elements (6, 9) and electrically and mechanically connected to them,
c) a further connection element (10),
d) at least one additional resistance element (3) separated from the first resistance element (2), which is arranged between one of the two connection elements (6, 9) of the first resistance element (2) and the further connection element (10) and is electrically and mechanically connected to these connection elements (6, 10),
**characterised in that**
e) the resistance elements (2, 3) are plate-shaped,
f) the connection elements (6, 9, 10), on the one hand, and the resistance elements (2, 3), on the other hand, consist of different materials,
g) the resistance arrangement (1, 37, 38) is fork-shaped, where the individual resistance elements (2, 3) lie in a row next to each other,
h) the common connection element (6) lies on one side of the row of resistance elements (2, 3), whereas the other connection elements (9, 10) lie on the other side of the row of resistance elements (2, 3),
i) the connection elements (6, 9, 10) are welded to the resistance elements (2, 3).

2. Resistance arrangement (1, 37, 38) according to Claim 1, **characterised in that** measurement connections (14-16), which are electrically and mechanically connected to the individual connection elements (6, 9, 10), are provided to record the electrical voltage drop over the resistance elements (2, 3).

3. Resistance arrangement (1, 37, 38) according to Claim 2, **characterised in that** the measurement connections (14-16) are each arranged directly adjacent to the resistance elements (2, 3) and/or the side edges of the connection elements (6, 9, 10).

4. Resistance arrangement (1, 37, 38) according to one of the preceding claims, **characterised by** a circuit board (20) with a measurement circuit, in which the circuit board (20) is arranged parallel to the plate-shaped resistance elements (2, 3) and electrically connected to them.

5. Resistance arrangement (1, 37, 38) according to Claim 4, **characterised in that** the circuit board (20) with a measurement circuit is mechanically connected to the connection elements (6, 9, 10) through the measurement connections (14-16).

6. Resistance arrangement (1, 37, 38) according to Claim 4, **characterised in that that** the circuit board (20) with the measurement circuit is mechanically connected through a spacer to the connection elements (6, 9, 10) and/or the resistance elements (2, 3).

7. Resistance arrangement (1, 37, 38) according to one of the preceding claims, **characterised in that** a perforation (17, 17.1-17.4) is arranged in the common connection element (6) of the resistance elements (2, 3) to influence the current distribution.

8. Resistance arrangement (1, 37, 38) according to Claim 7, **characterised in that** the perforation (17, 17.1 - 17.4) is arranged in the centre between the two resistance elements (2, 3).

9. Resistance arrangement (1, 37, 38) according to one of the preceding claims, **characterised in that** the connection elements (6, 9, 10) consist of copper or a copper compound.

10. Resistance arrangement (1, 37, 38) according to one of the preceding claims, **characterised in that** the resistance elements (2, 3) consist of Manganin®.

11. Resistance arrangement (1, 37, 38) according to one of the preceding claims, **characterised in that** the common connection element (6') of the two resistance elements (2') has two connection contacts (18') for conducting current.

12. Production method for resistance arrangements (1, 37, 38) with the following steps:
- mechanical and electrical connection of an elongated strip (28) of a resistance material with a corresponding elongated strip (27, 29) of an electrically-conducting material on each of its longitudinal edges,
- separation of the connected strips (27 - 29) into several resistance arrangements (1, 37, 38) along a plurality of transversely running separation lines (36),
**characterised in that**
in the individual resistance arrangements (1, 37, 38), transversely-running recesses (32 - 35) are made in each case between two adjacent separation lines (36), in which the recesses (32 - 35) starting from one longitudinal edge of the resistance arrangements (1, 37, 38) extend inward to at least the strip (28) of resistance material, in order to form in each case two connection elements (9, 10) separated from each other.

13. Production method according to Claim 12, **characterised in that** the transversely running recesses (32 - 35) extend inward, at least to the opposite lying strip (29) of electrically-conducting material, in order to form in each case two resistance elements (2, 3) separated from each other.

14. Production method according to one of the Claims 12 or 13, **characterised in that** the recesses (32-35) and/or the separation lines (36) are punched.

15. Production method according to one of the Claims 12 to 14, **characterised in that** the strips (27 - 29) are welded to each other.

16. Production method according to one of the Claims 13 to 15, **characterised in that** the individual resistance arrangements (1, 37, 38) are each electrically and/or mechanically connected to an integrated measurement circuit.

17. Measurement circuit, especially for measurement of battery current and generator current in a vehicle electrical system, with
- a first resistance element (48, 57, 64), which is arranged in a first circuit branch,
- a first voltage tap to measure the electrical voltage drop over the first resistance element (48, 57, 64),
- a second resistance element (49, 58, 63), which is arranged in a second circuit branch, as well as with
- a second voltage tap to measure the electrical voltage drop over the second resistance element (49, 58, 63),
- where the two resistance elements (48, 49, 57, 58, 63, 64) are arranged together in a resistance arrangement (47, 56, 62) and mechanically connected to each other, **characterised in that** the resistance arrangement (1, 2, 37, 38, 47, 56, 62) is designed according to one of the Claims 1 to 11.

18. Measurement circuit according to Claim 17, **characterised in that** the two resistance elements (48, 49, 57, 58, 63, 64) have a common connection element for current feed and/or current takeoff.

19. Measurement circuit according to Claim 18, **characterised in that** a third circuit branch with a starter (52, 60, 67) is connected to the common connection element.

20. Measurement circuit according to one of the Claims 17 to 19, **characterised in that** a battery (51, 59, 65) is arranged in the first circuit branch and at least one electrical load in the second circuit branch.

21. Measurement circuit according to one of the Claims 17 to 20, **characterised in that** a battery (51, 59, 65) is arranged in the first circuit branch and a generator (50, 66) in the second circuit branch.

22. Measurement circuit according to Claim 21, **characterised in that** a third circuit branch with a battery (59') is connected to the common connection element.

23. Measurement circuit according to Claim 22, **characterised in that** a starter (67') is arranged in the first circuit branch and a generator (66') in the second circuit branch.

24. Measurement circuit according to Claim 22, **characterised in that** a parallel circuit of a starter (60') and a generator (61') is arranged in the first circuit branch and at least one electrical load is arranged in the second circuit branch.

25. Measurement circuit according to one of the Claims 17 to 24, **characterised in that** the resistance arrangement (1, 37, 38) is connected to ground.

26. Measurement circuit according to one of the Claims 17 to 25, **characterised in that** the resistance arrangement (1, 37, 38, 47, 56, 62) is connected on the voltage side.

## Revendications

1. Dispositif de résistances (1, 37, 38), en particulier pour la mesure du courant de batterie et du courant d'alternateur dans un réseau de bord d'un véhicule automobile, avec
a) deux éléments de connexion en forme de plaque (6, 9) séparés l'un de l'autre,
b) un premier élément résistif (2) disposé entre les deux éléments de connexion (6, 9) et relié électriquement et mécaniquement à ces derniers,
c) un autre élément de connexion (10),
d) au moins un autre élément résistif (3) qui est séparé du premier élément résistif (2) et disposé entre l'un des deux éléments de connexion (6, 9) du premier élément résistif (2) et l'autre élément de connexion (10) et relié électriquement et mécaniquement à ces éléments de connexion (6, 10),
**caractérisé en ce que**
e) les éléments résistifs (2, 3) sont en forme de plaque,
f) les éléments de connexion (6, 9, 10) d'une part et les éléments résistifs (2, 3) d'autre part sont faits de matériaux différents,
g) le dispositif de résistances (1, 37, 38) a une forme de fourche dans laquelle les éléments résistifs (2, 3) individuels se trouvent côte à côte dans une rangée,
h) l'élément de connexion commun (6) se trouve sur un côté de la rangée d'éléments résistifs (2, 3) tandis que les autres éléments de connexion (9, 10) se trouvent sur l'autre côté de la rangée d'éléments résistifs (2, 3),
i) les éléments de connexion (6, 9, 10) sont soudés aux éléments résistifs (2, 3).

2. Dispositif de résistances (1, 37, 38) selon la revendication 1, **caractérisé en ce que**, pour détecter la chute de tension électrique dans les éléments résistifs (2, 3), il est prévu des connexions de mesure (14-16) qui sont reliées électriquement et mécaniquement aux éléments de connexion (6, 9, 10) individuels.

3. Dispositif de résistances (1, 37, 38) selon la revendication 2, **caractérisé en ce que** les connexions de mesure (14-16) sont disposées chacune directement adjacente aux éléments résistifs (2, 3) et/ou à des arêtes latérales des éléments de connexion (6, 9, 10).

4. Dispositif de résistances (1, 37, 38) selon l'une des revendications précédentes, **caractérisé par** une platine (20) avec un circuit de mesure, la platine (20) étant disposée parallèlement aux éléments résistifs en forme de plaque (2, 3) et reliée électriquement à ces derniers.

5. Dispositif de résistances (1, 37, 38) selon la revendication 4, **caractérisé en ce que** la platine (20) avec le circuit de mesure est reliée mécaniquement aux éléments de connexion (6, 9, 10) au moyen des connexions de mesure (14 à 16).

6. Dispositif de résistances (1, 37, 38) selon la revendication 4, **caractérisé en ce que** la platine (20) avec le circuit de mesure est reliée mécaniquement aux éléments de connexion (6, 9, 10) et/ou aux éléments résistifs (2, 3) au moyen d'une entretoise.

7. Dispositif de résistances (1, 37, 38) selon l'une des revendications précédentes, **caractérisé en ce qu'**une ouverture (17, 17.1 à 17.4) est ménagée dans l'élément de connexion commun (6) des éléments résistifs (2, 3) afin de pouvoir agir sur la répartition du courant.

8. Dispositif de résistances (1, 37, 38) selon la revendication 7, **caractérisé en ce que** l'ouverture (17, 17.1 à 17.4) est disposée au milieu entre les deux éléments résistifs (2, 3).

9. Dispositif de résistances (1, 37, 38) selon l'une des revendications précédentes, **caractérisé en ce que** les éléments de connexion (6, 9, 10) sont en cuivre ou un composé de cuivre.

10. Dispositif de résistances (1, 37, 38) selon l'une des revendications précédentes, **caractérisé en ce que** les éléments résistifs (2, 3) sont en Manganine®.

11. Dispositif de résistances (1, 37, 38) selon l'une des revendications précédentes, **caractérisé en ce que** l'élément de connexion (6') commun aux deux éléments résistifs (2') présente deux contacts de raccordement (18') pour évacuer le courant.

12. Procédé de fabrication dispositifs de résistances (1, 37, 38), comprenant les étapes suivantes :
- liaison mécanique et électrique d'une bande allongée (28) faite d'un matériau résistif, sur chacun de ses bords longitudinaux, avec une bande allongée (27, 29) faite d'un matériau électriquement conducteur,
- séparation des bandes (27 à 29) reliées à l'autre en plusieurs agencements de résistances (1, 37, 38) le long de plusieurs lignes de séparation (36) s'étendant perpendiculairement,
**caractérisé en ce que**, dans les dispositifs de résistances (1, 37, 38) individuels, des encoches (32 à 35) s'étendant perpendiculairement sont réalisées respectivement entre deux lignes de séparation (36) voisines, les encoches (32 à 35) s'étendant vers l'intérieur depuis un bord longitudinal de l'agencement de résistances (1, 37, 38) au moins jusqu'à la bande (28) en matériau résistif de façon à former à chaque fois deux éléments de connexion (9, 10) séparés l'un de l'autre.

13. Procédé de fabrication selon la revendication 12, **caractérisé en ce que** les encoches (32-35) s'étendent perpendiculairement vers l'intérieur au moins jusqu'à la bande opposée (29) en matériau électriquement conducteur de façon à former à chaque fois deux éléments résistifs (2, 3) séparés l'un de l'autre.

14. Procédé de fabrication selon la revendication 12 ou 13, **caractérisé en ce que** les encoches (32 à 35) et/ou les lignes de séparation (36) sont poinçonnées.

15. Procédé de fabrication selon l'une des revendications 12 à 14, **caractérisé en ce que** les bandes (27 à 29) sont soudées les unes aux autres.

16. Procédé de fabrication selon l'une des revendications 13 à 15, **caractérisé en ce que** les différents agencements de résistances (1, 37, 38) sont reliés électriquement et/ou mécaniquement chacun à un circuit de mesure.

17. Circuit de mesure, en particulier pour la mesure du courant de batterie et du courant d'alternateur dans un réseau de bord d'un véhicule automobile, avec
- un premier élément résistif (48, 57, 64) qui est disposé dans une première branche de circuit,
- une première prise de tension pour la mesure de la chute de tension électrique dans le premier élément résistif (48, 57, 64),
- un deuxième élément résistif (49, 58, 63) qui est disposé dans une deuxième branche de circuit, ainsi qu'avec
- une deuxième prise de tension pour la mesure de la chute de tension électrique dans le deuxième élément résistif (49, 58, 63),
- les éléments résistifs (48, 49, 57, 58, 63, 64) étant disposés ensemble et reliés mécaniquement en un agencement de résistances (47, 56, 62),
**caractérisé en ce que** l'agencement de résistances (1, 2, 37, 38, 47, 56, 62) est réalisé conformément à l'une des revendications 1 à 11.

18. Circuit de mesure selon la revendication 17, **caractérisé en ce que** les deux éléments résistifs (48, 49, 57, 58, 63, 64) présentent un élément de connexion commun pour alimenter et/ou évacuer le courant.

19. Circuit de mesure selon la revendication 18, **caractérisé en ce qu'**une troisième branche de circuit avec un démarreur (52, 60, 67) est reliée à l'élément de connexion commun.

20. Circuit de mesure selon l'une des revendications 17 à 19, **caractérisé en ce qu'**une batterie (51, 59, 65) est disposée dans la première branche de circuit et au moins un élément utilisateur est disposé dans la deuxième branche de circuit.

21. Circuit de mesure selon l'une des revendications 17 à 20, **caractérisé en ce qu'**une batterie (51, 59, 65) est disposée dans la première branche de circuit et un générateur (50, 66) est disposé dans la deuxième branche de circuit.

22. Circuit de mesure selon la revendication 21, **caractérisé en ce qu'**une troisième branche de circuit avec une batterie (59') est reliée à l'élément de connexion commun.

23. Circuit de mesure selon la revendication 22, **caractérisé en ce qu'**un démarreur (67') est disposé dans la première branche de circuit et un générateur (66') est disposé dans la deuxième branche de circuit.

24. Circuit de mesure selon la revendication 22, **caractérisé en ce qu'**un montage en parallèle constitué d'un démarreur (60') et d'un générateur (61') est disposé dans la première branche de circuit tandis qu'au moins un élément utilisateur est disposé dans la deuxième branche de circuit.

25. Circuit de mesure selon l'une des revendications 17 à 24, **caractérisé en ce que** le dispositif de résistances (1, 37, 38) est connecté côté masse.

26. Circuit de mesure selon l'une des revendications 17 à 25, **caractérisé en ce que** le dispositif de résistances (1, 37, 38, 47, 56, 62) est connecté côté tension.
